# EUROPÄISCHE PATENTSCHRIFT

(11) **EP 2 309 238 B1**
(45) Veröffentlichungstag und Bekanntmachung des Hinweises auf die Patenterteilung: **04.05.2016**
(21) Anmeldenummer: 10186761.2
(22) Anmeldetag: 06.10.2010
(51) Int. Cl.: G01K 1/14, G01K 1/16

(54) **Heizkostenverteiler**
Heating cost distributor
Répartiteur de coûts de chauffage

(30) Priorität: 10.10.2009 DE 102009048940
(43) Veröffentlichungstag der Anmeldung: 13.04.2011
(73) Patentinhaber: QUNDIS GmbH, 99098 Erfurt (DE)
(72) Erfinder: Dobeneck, Wolfgang, 99996 Menteroda OT Urbach (DE); Gerner, René, 99974 Mühlhausen (DE); Wöhrstein, Hermann, 78052 Villingen-Schwenningen (DE); Hintz, Fred, 78112 St. Georgen (DE)
(74) Vertreter: Liedtke, Markus

(56) Entgegenhaltungen:
- EP-A1- 1 925 924
- EP-A2- 1 077 366
- DE-A1- 4 429 934
- DE-C1- 10 146 207

## Beschreibung

Die Erfindung betrifft einen Heizkostenverteiler nach den Merkmalen des Oberbegriffs des Anspruchs 1.

Elektronische Heizkostenverteiler dienen der Messung der von einem Heizkörper abgegebenen Wärmemenge. Dazu werden Temperatursensoren benötigt, die die Oberflächentemperatur des Heizkörpers und bei den Zweifühlergeräten auch die Raumlufttemperatur erfassen müssen.

Aus dem Stand der Technik ist, wie in der DE 10 2004 023 989 B3 beschrieben, ein elektronischer Heizkostenverteiler bekannt. Bei diesem elektronischen Heizkostenverteiler mit einer in einem Gehäuse angeordneten Leiterplatte, auf deren Bestückungsseite an gegenüberliegenden Leiterplattenenden ein Raumlufttemperatursensor und ein Heizkörpertemperatursensor vorgesehen sind, ist dem Heizkörpertemperatursensor ein erstes, auf der Bestückungsseite angeordnetes, wärmeleitfähiges und elastisch verformbares Element zugeordnet. Dem Raumlufttemperatursensor ist ein zweites, an einer Gehäuseinnenseite angeordnetes, wärmeleitfähiges und elastisch verformbares Element zugeordnet, das mit dem Raumlufttemperatursensor über eine Durchkontaktierung von der Bestückungsseite zu dieser gegenüberliegenden Plattenseite der Leiterplatte gekoppelt ist.

Des Weiteren wird in der DE 20 2004 007 802 U1 ein elektronischer Heizkostenverteiler beschrieben. Der Heizkostenverteiler umfasst ein Gehäuse, welches ein Gehäusevorderteil und eine Rückseite aufweist. In dem Gehäuse ist eine Leiterplatte angeordnet, auf der ein Heizkörpertemperatursensor und ein zu diesem beabstandeter Raumlufttemperatursensor angeordnet sind. Dem Raumlufttemperatursensor ist ein thermisch isolierendes Element zugeordnet, welches zwischen dem Raumlufttemperatursensor und der Rückseite angeordnet ist.

Aus der EP 1 925 924 A1 ist ein Heizkostenverteiler zur Erfassung der von einem Heizkörper in einem Raum abgegebenen Wärmemenge bekannt, mit einem Gehäuse und einer an einer Heizkörperoberfläche montierbaren wärmeleitfähigen Trägerplatte, welche eine Rückwand für das Gehäuse bildet und einer innerhalb des Gehäuses angeordneten Leiterplatte, die einen Heizkörpertemperatursensor und einen Raumlufttemperatursensor aufweist.

In der DE 44 29 934 A1 wird ein Heizkostenverteiler beschrieben, welcher ein Gehäuse, einen Heizkörpersensor, einen Raumluftsensor und eine Leiterplatte aufweist. Der Raumluftsensor ist auf einem flexiblen Steg einer LCD-Anzeige befestigt und über eine flexible Zuleitung mit einer elektronischen Schaltungsanordnung der Leiterplatte verbunden.

Der Erfindung liegt die Aufgabe zugrunde, einen verbesserten Heizkostenverteiler anzugeben.

Die Aufgabe wird erfindungsgemäß gelöst durch einen Heizkostenverteiler mit den Merkmalen des Anspruchs 1.

Vorteilhafte Ausgestaltungen der Erfindung sind Gegenstand der Unteransprüche.

Ein Heizkostenverteiler zur Messung einer von einem Heizkörper abgegebenen Wärmemenge umfasst ein Gehäuse, welches ein Gehäusevorderteil und eine Gehäuserückseite aufweist, einen Heizkörpertemperatursensor, einen Raumlufttemperatursensor und eine Hauptleiterplatte.

Erfindungsgemäß ist die Hauptleiterplatte in Längsrichtung des Heizkostenverteilers im Gehäuse angeordnet und senkrecht zu dieser Hauptleiterplatte ist eine Sensorleiterplatte angeordnet, wobei ein erstes Ende der Sensorleiterplatte in einer Durchkontaktierungsöffnung der Hauptleiterplatte angeordnet ist und ein zweites Ende der Sensorleiterplatte im Bereich des Gehäusevorderteils angeordnet ist, wobei die Sensorleiterplatte mit der Hauptleiterplatte im Bereich der Durchkontaktierungsöffnung über Hauptleiterplattenkontakte und Sensorleiterplattenkontakte elektrisch kontaktiert ist und wobei auf dem zweiten Ende der Sensorleiterplatte der Raumlufttemperatursensor angeordnet ist.

Auf diese Weise ist eine thermische Entkoppelung des Raumlufttemperatursensors von einem Heizkörper, an welchem der Heizkostenverteiler angeordnet ist, optimiert, da der Raumlufttemperatursensor möglichst weit entfernt vom Heizkörper und vom Heizkörpertemperatursensor im Bereich des Gehäusevorderteils, d. h. an einer Vorderseite des Gehäuses, angeordnet ist.

Des Weiteren ist auch eine Positionierung der beiden Sensoren optimiert, da der Heizkörpertemperatursensor möglichst nah am Heizkörper positioniert ist und der Raumlufttemperatursensor durch die senkrecht zur Hauptleiterplatte angeordnete Sensorleiterplatte möglichst weit entfernt vom Heizkörper und möglichst nah an der Raumluft, deren Temperatur zu ermitteln ist, positioniert ist.

Durch die optimierte thermische Entkopplung und die optimierte Positionierung des Raumlufttemperatursensors ist eine korrekte Ermittlung sowohl der Heizkörpertemperatur als auch der Raumlufttemperatur ermöglicht. Durch auf diese Weise verbesserte Messeigenschaften ist der Heizkostenverteiler für eine Vielzahl von Anwendungsgebieten geeignet, insbesondere auch für Niedertemperaturheizungen.

Als Raumlufttemperatursensor ist vorzugsweise ein kostengünstiger so genannter NTC-Widerstand (Negative Temperature Coefficient Thermistors) in SMD-Bauform (Surface-mounted device), d. h. als oberflächenmontierbares Bauelement einsetzbar und automatisiert auf der Sensorleiterplatte montierbar, so dass Herstellungskosten und Herstellungszeiten minimiert sind und große Stückzahlen produzierbar sind.

Zudem sind die Herstellungskosten und Herstellungszeiten zusätzlich reduziert, da die Sensorleiterplatten in so genannten Leiterplattennutzen mit mindestens 500 nebeneinander und übereinander angeordneten und zunächst noch miteinander verbundenen Leiterplatten pro Nutzen automatisiert herstellbar sind, wobei zunächst Leiterzüge und durch Metallisierungen die Sensorleiterplattenkontakte auf jeder Sensorleiterplatte zu erzeugen und Raumlufttemperatursensoren aufzulöten sind und danach die Sensorleiterplatten zu vereinzeln sind, so dass sie beispielsweise magaziniert und automatisiert weiterzuverarbeiten, d. h. in die Hauptleiterplatten einzusetzen und mit diesen zu verlöten sind. Auch die Hauptleiterplatten sind automatisiert und dadurch kostengünstig und in großen Stückzahlen herstellbar und bestückbar.

Besonders bevorzugt ist das zweite Ende der Sensorleiterplatte an einem dünnwandigen Bereich des Gehäusevorderteils angeordnet, so dass die thermische Kopplung des Raumlufttemperatursensors an die Raumluft nicht durch das Gehäusevorderteil behindert ist. Dieser dünnwandige Bereich ist durch eine dünnwandige Ausformung des Gehäuses oder durch eine Öffnung im Gehäuse gebildet, welche durch ein zusätzliches dünnwandiges Formteil verschlossen ist. Dadurch ist das Gehäuse des Heizkostenverteilers abgedichtet, so dass weder Schmutz noch Feuchtigkeit eindringen können. Durch diesen dünnwandigen Bereich ist der Raumlufttemperatursensor sehr gut mit der Raumluft thermisch gekoppelt.

Um diese thermische Kopplung weiter zu optimieren, ist vorzugsweise zwischen dem Raumlufttemperatursensor und dem dünnwandigen Bereich des Gehäusevorderteils ein Wärmeleitmittel angeordnet, so dass der Raumlufttemperatursensor über dieses Wärmeleitmittel optimal mit dem dünnwandigen Bereich des Gehäusevorderteils und dadurch mit der Raumluft thermisch gekoppelt ist. Dieses Wärmeleitmittel ist beispielsweise Wärmeleitpaste, welche zwischen dem Raumlufttemperatursensor und dem dünnwandigen Bereich des Gehäusevorderteils eingebracht ist.

Vorzugsweise bedecken die Sensorleiterplattenkontakte im Bereich des ersten Endes der Sensorleiterplatte jeweils eine Schmalseite der Sensorleiterplatte vollständig und einen angrenzenden Bereich einer unteren und einer oberen Breitseite der Sensorleiterplatte nahezu bis zur jeweiligen Seitenmitte. Dadurch ist eine optimale elektrische und mechanische Verbindung der Sensorleiterplatte mit der Hauptleiterplatte durch einen Lötvorgang sichergestellt.

Zudem ist die Sensorleiterplatte auf diese Weise analog zu massiven elektrischen Bauelementen in einem automatisierten Fertigungsprozess einfach, schnell und kostengünstig in die Hauptleiterplatte einsetzbar und mit dieser durch selektives Löten automatisiert verlötbar, wobei in der Hauptleiterplatte zum Einsetzen der Sensorleiterplatte eine Struktur aus Durchkontaktierungen zu bilden ist, welche durch Freifräsungen zu der einzelnen Durchkontaktierungsöffnung verbindbar sind, in welche die Sensorleiterplatte einsetzbar ist. Dies ist ebenfalls automatisiert und dadurch einfach, schnell und kostengünstig durchführbar. Durch diese automatisierte Fertigung sind Montageprobleme minimiert.

Bevorzugt sind Leiterzüge zu einer elektrischen Kontaktierung der Sensorleiterplattenkontakte mit dem Raumlufttemperatursensor auf der Sensorleiterplatte mäanderförmig angeordnet. Diese Leiterzüge sind möglichst dünn ausgeführt. Auch die Sensorleiterplatte weist einen möglichst geringen Querschnitt auf. Durch geringe Materialstärken der Sensorleiterplatte und der Leiterzüge und durch die mäanderförmige Anordnung der Leiterzüge ist die thermische Entkopplung des Raumlufttemperatursensors vom mit der Hauptleiterplatte verbundenen ersten Ende der Sensorleiterplatte optimiert, so dass eine Wärmeübertragung von der Hauptleiterplatte, welche näher am Heizkörper angeordnet ist und welche möglicherweise Wärme erzeugende elektronische Bauelemente aufweist, über die Sensorleiterplatte auf den Raumlufttemperatursensor sehr stark reduziert ist.

Vorteilhafterweise ist die Hauptleiterplatte in einem mittleren Bereich zwischen dem Gehäusevorderteil und der Gehäuserückseite des Gehäuses angeordnet. Durch die mittige Anordnung der Hauptleiterplatte im Gehäuse ist zwischen der Hauptleiterplatte und dem Gehäusevorderteil ein ausreichender Bauraum für einen Senderteil und eine Antenne vorhanden, so dass eine Datenfernübertragung des Heizkostenverteilers ermöglicht ist, bei welcher der Senderteil und die Antenne in eben diesem Gehäusevorderteil zu installieren sind, um eine sichere Datenfernübertragung zu ermöglichen.

Des Weiteren wirkt die Hauptleiterplatte durch deren mittige Anordnung im Gehäuse als eine Temperaturbarriere zwischen der dem Heizköper zugewandten Gehäuserückseite und dem einem Inneren eines Raumes zugewandten Gehäusevorderteil, in welchem der Raumlufttemperatursensor angeordnet ist, um die Temperatur der Raumluft zu ermitteln. Durch diese Temperaturbarriere ist die thermische Entkopplung des Raumlufttemperatursensors vom Heizkörper und vom Heizkörpertemperatursensor optimiert. Zusätzlich ist beispielsweise zwischen der Hauptleiterplatte und der Gehäuserückseite im Gehäuse ein thermisch isolierendes Element anordbar, durch welches die thermische Entkopplung weiter verbessert ist.

Zweckmäßigerweise ist der Heizkörpertemperatursensor mit der Gehäuserückseite des Gehäuses thermisch kontaktiert, um eine optimale thermische Kopplung an den Heizkörper und daraus resultierend eine exakte Ermittlung der Heizkörpertemperatur sicherzustellen.

Um dies zu ermöglichen und gleichzeitig eine optimierte thermische Entkopplung der Hauptleiterplatte und dadurch der mit dieser verbundenen Sensorleiterplatte und des Raumlufttemperatursensors sicherzustellen, ist der Heizkörpertemperatursensor vorzugsweise im Gehäuse an der Gehäuserückseite und/oder an zumindest einem Wärmeleitelement der Gehäuserückseite angeordnet, beispielsweise mittels eines Federelementes angepresst, und besonders bevorzugt von der Hauptleiterplatte beabstandet und lediglich über eine Verdrahtung mit dieser elektrisch kontaktiert.

Ausführungsbeispiele der Erfindung werden im Folgenden anhand von Zeichnungen näher erläutert.

Darin zeigen:
- Figur 1: einen Heizkostenverteiler von vorn,
- Figur 2: eine Schnittdarstellung eines Heizkostenverteilers entlang der Schnittlinie II-II in Figur 1,
- Figur 3: einen Leiterplattennutzen in Draufsicht,
- Figur 4: eine Detailansicht des Leiterplattennutzens aus Figur 3,
- Figur 5: eine perspektivische Darstellung einer mit einer Hauptleiterplatte verbundenen Sensorleiterplatte von oben, und
- Figur 6: eine perspektivische Darstellung einer mit einer Hauptleiterplatte verbundenen Sensorleiterplatte von unten.

Einander entsprechende Teile sind in allen Figuren mit den gleichen Bezugszeichen versehen.

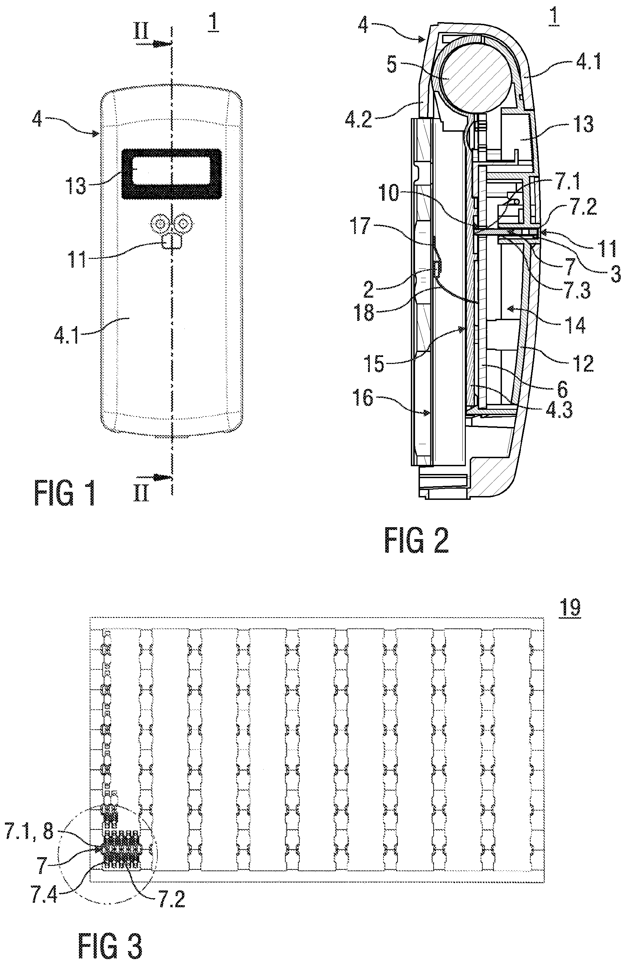

Figur 1 zeigt einen Heizkostenverteiler 1 zur Messung einer von einem nicht näher dargestellten Heizkörper abgegebenen Wärmemenge von vorn und Figur 2 eine Schnittdarstellung des Heizkostenverteilers 1 entlang der Schnittlinie II-II. Der Heizkostenverteiler 1 weist einen Heizkörpertemperatursensor 2 und einen Raumlufttemperatursensor 3 auf, welche innerhalb eines Gehäuses 4 des Heizkostenverteilers 1 angeordnet sind, wobei das Gehäuse 4 ein Gehäusevorderteil 4.1 und eine Gehäuserückseite 4.2 aufweist. Des Weiteren ist im Gehäuse 4 eine Batterie 5 zur Energieversorgung des Heizkostenverteilers 1 angeordnet.

Eine Hauptleiterplatte 6 ist in Längsrichtung des Heizkostenverteilers 1 in einem mittleren Bereich zwischen dem Gehäusevorderteil 4.1 und der Gehäuserückseite 4.2 des Gehäuses 4 angeordnet. Senkrecht zu dieser Hauptleiterplatte 6 ist eine Sensorleiterplatte 7 angeordnet.

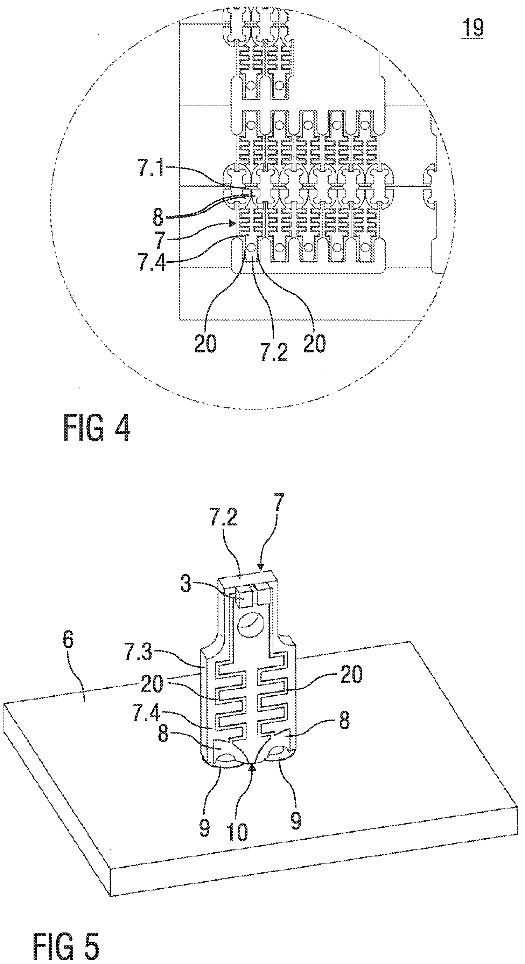

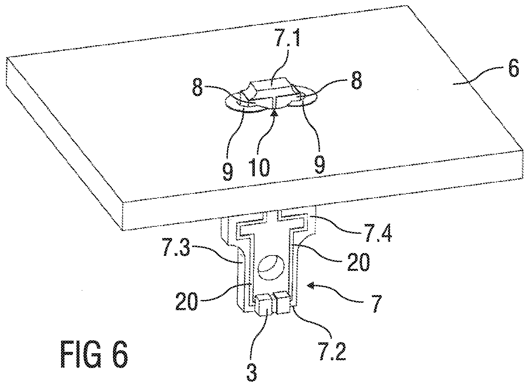

Ein erstes Ende 7.1 der Sensorleiterplatte 7 weist Sensorleiterplattenkontakte 8 auf und ist in einer mit Hauptleiterplattenkontakten 9 versehenen Durchkontaktierungsöffnung 10 der Hauptleiterplatte 6 angeordnet und auf diese Weise elektrisch mit der Hauptleiterplatte 6 kontaktiert. Die Sensorleiterplattenkontakte 8 sind in den Figuren 3 und 4 näher dargestellt und die Hauptleiterplattenkontakte 9 sind in den Figuren 5 und 6 näher dargestellt.

Auf einem zweiten Ende 7.2 der Sensorleiterplatte 7 ist der Raumlufttemperatursensor 3 angeordnet. Dieses zweite Ende 7.2 der Sensorleiterplatte 7 ist an einem dünnwandigen Bereich 11 des Gehäusevorderteils 4.1 angeordnet. Dadurch ist eine thermische Entkoppelung des Raumlufttemperatursensors 3 vom Heizkörper, an welchem der Heizkostenverteiler 1 anordbar ist, optimiert, da der Raumlufttemperatursensor 3 möglichst weit entfernt vom Heizkörper angeordnet ist.

Der dünnwandige Bereich 11 ist im hier dargestellten Beispiel durch eine Öffnung im Gehäuse 4 gebildet, welche durch ein zusätzliches dünnwandiges Formteil verschlossen ist. Dieses Formteil ist gebildet durch einen Träger 12, in welchem auch eine Anzeigeeinheit 13, beispielsweise ein LC-Display, befestigt ist und welcher im Bereich der Öffnung im Gehäuse 4 sehr dünnwandig ausgeformt ist. Dadurch ist das Gehäuse 4 des Heizkostenverteilers 1 abgedichtet, so dass weder Schmutz noch Feuchtigkeit eindringen können. Durch diesen dünnwandigen Bereich 11 ist der Raumlufttemperatursensor 3 in gutem thermischen Kontakt mit der Raumluft, deren Temperatur zu ermitteln ist.

Um die thermische Kopplung des Raumlufttemperatursensors 3 mit der Raumluft weiter zu optimieren, ist vorzugsweise zwischen dem Raumlufttemperatursensor 3 und dem dünnwandigen Bereich 11 des Gehäusevorderteils 4.1 ein hier nicht näher dargestelltes Wärmeleitmittel angeordnet, so dass der Raumlufttemperatursensor 3 über dieses Wärmeleitmittel optimal mit dem dünnwandigen Bereich 11 des Gehäusevorderteils 4.1 und dadurch mit der Raumluft thermisch gekoppelt ist. Dieses Wärmeleitmittel ist beispielsweise Wärmeleitpaste, welche zwischen dem Raumlufttemperatursensor 3 und dem dünnwandigen Bereich 11 des Gehäusevorderteils 4.1 eingebracht ist.

Da der Raumlufttemperatursensor 3 mittels der Sensorleiterplatte 7 von der Hauptleiterplatte 6 beabstandet und optimal im Bereich des Gehäusevorderteils 4.1 positioniert ist, ist die Hauptleiterplatte 6 ebenfalls optimal mittig im Gehäuse 4 positionierbar, so dass zwischen der Hauptleiterplatte 6 und dem Gehäusevorderteil 4.1 ein ausreichender Bauraum 14 für einen nicht näher dargestellten Senderteil und eine nicht näher dargestellte Antenne vorhanden ist. Dadurch ist eine Datenfernübertragung des Heizkostenverteilers 1 ermöglicht, bei welcher der Senderteil und die Antenne in eben diesem Gehäusevorderteil 4.1 zu installieren sind, um eine sichere Datenfernübertragung zu ermöglichen.

Des Weiteren wirkt die Hauptleiterplatte 6 durch deren mittige Anordnung im Gehäuse 4 als eine Temperaturbarriere zwischen der dem Heizköper zugewandten Gehäuserückseite 4.2 und dem einem Inneren eines Raumes zugewandten Gehäusevorderteil 4.1, in welchem der Raumlufttemperatursensor 3 angeordnet ist, um die Temperatur der Raumluft zu ermitteln. Durch diese Temperaturbarriere ist die thermische Entkopplung des Raumlufttemperatursensors 3 vom Heizkörper und vom Heizkörpertemperatursensor 2 optimiert.

Des Weiteren ist, wie hier dargestellt, zwischen der Hauptleiterplatte 6 und der Gehäuserückseite 4.2 parallel zur Hauptleiterplatte 6 eine Gehäusemittelwand 4.3 angeordnet, welche ebenfalls als Temperaturbarriere zwischen der am Heizkörper angeordneten Gehäuserückseite 4.2 und dem Gehäusevorderteil 4.1 wirkt, in dessen Bereich der Raumlufttemperatursensor 3 angeordnet ist. Diese Gehäusemittelwand 4.3 ist beispielsweise durch eine entsprechende Ausformung des Gehäuses 4 oder durch eine entsprechende Ausformung des Trägers 12 gebildet. Zusätzlich ist zwischen der Gehäusemittelwand 4.3 und der Gehäuserückseite 4.2 im Gehäuse 4 ein thermisch isolierendes Element 15 angeordnet, durch welches die thermische Entkopplung weiter verbessert ist. Alternativ kann auch die hier dargestellte Gehäusemittelwand 4.3 bereits als thermisch isolierendes Element 15 ausgebildet sein.

Der Heizkörpertemperatursensor 2 ist im Gehäuse 4 an einem Wärmeleitelement 16 der Gehäuserückseite 4.2 angeordnet. Im hier dargestellten Beispiel ist der Heizkörpertemperatursensor 2 mittels eines Federelementes 17 an das Wärmeleitelement 16 angepresst. Daraus resultiert eine optimale thermische Kopplung an die Gehäuserückseite 4.2 und über diese an den Heizkörper, an welchem der Heizkostenverteiler 1 anordbar ist. Dadurch ist eine exakte Ermittlung der Heizkörpertemperatur ermöglicht.

Im hier dargestellten Beispiel ist der Heizkörpertemperatursensor 2 von der Hauptleiterplatte 6 beabstandet und lediglich über eine Verdrahtung 18 mit dieser elektrisch kontaktiert. Dadurch ist der Heizkörpertemperatursensor 2 von der Hauptleiterplatte 6 sehr gut thermisch entkoppelt, so dass keine Wärme vom Heizkörper über den Heizkörpertemperatursensor 2 auf die Hauptleiterplatte 6 und von dieser über die Sensorleiterplatte 7 auf den Raumlufttemperatursensor 3 übertragbar ist. Eine Verfälschung von Sensorergebnissen des Raumlufttemperatursensors 3 ist dadurch verhindert.

Durch die Sensorleiterplatte 7 ist eine Positionierung der beiden Sensoren 2, 3 optimiert, da der Heizkörpertemperatursensor 2 möglichst nah am Heizkörper positioniert ist und der Raumlufttemperatursensor 3 durch die senkrecht zur Hauptleiterplatte 6 angeordnete Sensorleiterplatte 7 möglichst weit entfernt vom Heizkörper und möglichst nah an der Raumluft, deren Temperatur zu ermitteln ist, positioniert ist.

Durch die optimierte thermische Entkopplung und die optimierte Positionierung des Raumlufttemperatursensors 3 ist eine korrekte Ermittlung sowohl der Heizkörpertemperatur als auch der Raumlufttemperatur ermöglicht. Durch auf diese Weise verbesserte Messeigenschaften ist der Heizkostenverteiler 1 für eine Vielzahl von Anwendungsgebieten geeignet, insbesondere auch für Niedertemperaturheizungen.

Die Sensorleiterplatte 7 ist zu geringen Herstellungskosten und in großen Stückzahlen automatisiert herstellbar, beispielsweise, wie in den Figuren 3 und 4 dargestellt, mittels so genannter Leiterplattennutzen 19 mit mindestens 500 nebeneinander und übereinander angeordneten und zunächst noch miteinander verbundenen Sensorleiterplatten 7 pro Nutzen 19.

Dabei sind zunächst Strukturen der Sensorleiterplatten 7 und Leiterzüge 20 und durch Metallisierungen die Sensorleiterplattenkontakte 8 auf jeder Sensorleiterplatte 7 zu erzeugen und Raumlufttemperatursensoren 3 aufzulöten. Die Strukturen, Sensorleiterplattenkontakte 8 und Leiterzüge 20 sind beispielsweise durch Belichten, Ätzen, Freifräsen und Ritzen von Trennlinien erzeugbar.

Danach sind die Sensorleiterplatten 7 entlang der Trennlinien durch Zerschneiden zu vereinzeln, so dass sie beispielsweise magaziniert und automatisiert weiterzuverarbeiten sind, d. h. in die Hauptleiterplatten 6 einzusetzen und mit diesen zu verlöten sind. Dieses automatisierte Verlöten ist beispielsweise durch Aufbringen einer Lötpaste auf die Hauptleiterplattenkontakte 9 und/oder auf die Sensorleiterplattenkontakte 8 und Verlöten mittels Licht bzw. Laser oder mittels eines robotergeführten Lötkolbens durchführbar.

Auch die Hauptleiterplatten 6 sind automatisiert und dadurch kostengünstig und in großen Stückzahlen herstellbar und bestückbar.

Als Raumlufttemperatursensor 3 ist vorzugsweise ein kostengünstiger so genannter NTC-Widerstand (Negative Temperature Coefficient Thermistors) in SMD-Bauform (Surface-mounted device), d. h. als oberflächenmontierbares Bauelement einsetzbar und automatisiert auf der Sensorleiterplatte 7 montierbar, so dass Herstellungskosten und Herstellungszeiten minimiert sind und große Stückzahlen produzierbar sind.

Wie in den Figuren 5 und 6 dargestellt, sind Leiterzüge 20 zu einer elektrischen Kontaktierung der Sensorleiterplattenkontakte 8 mit dem Raumlufttemperatursensor 3 auf der Sensorleiterplatte 7 mäanderförmig angeordnet. Diese Leiterzüge 20 sind möglichst dünn ausgeführt. Auch die Sensorleiterplatte 7 weist einen möglichst geringen Querschnitt auf.

Durch geringe Materialstärken der Sensorleiterplatte 7 und der Leiterzüge 20 und durch die mäanderförmige Anordnung der Leiterzüge 20 ist die thermische Entkopplung des Raumlufttemperatursensors 3 vom mit der Hauptleiterplatte 6 verbundenen ersten Ende 7.1 der Sensorleiterplatte 7 optimiert. Dadurch ist eine Wärmeübertragung von der Hauptleiterplatte 6, welche näher am Heizkörper angeordnet ist und welche hier nicht näher dargestellte elektronische Bauelemente aufweist, die möglicherweise zusätzlich Wärme erzeugen, über die Sensorleiterplatte 7 auf den Raumlufttemperatursensor 3 sehr stark reduziert.

Die Sensorleiterplattenkontakte 8 bedecken im Bereich des ersten Endes 7.1 der Sensorleiterplatte 7 jeweils eine Schmalseite 7.3 der Sensorleiterplatte 7 vollständig und einen angrenzenden Bereich einer unteren und einer oberen Breitseite 7.4 der Sensorleiterplatte 7 nahezu bis zur jeweiligen Seitenmitte. Dadurch ist eine optimale elektrische und mechanische Verbindung der Sensorleiterplatte 7 mit der Hauptleiterplatte 6 durch einen Lötvorgang sichergestellt.

Zudem ist die Sensorleiterplatte 7 auf diese Weise analog zu massiven elektrischen Bauelementen in einem automatisierten Fertigungsprozess und dadurch einfach, schnell und kostengünstig in die Hauptleiterplatte 6 einsetzbar und mit dieser durch selektives Löten automatisiert verlötbar. Um die Sensorleiterplatte 7 in die Hauptleiterplatte 6 einsetzen und mit dieser verlöten zu können, ist in der Hauptleiterplatte 6 eine Struktur aus Durchkontaktierungen zu bilden, welche durch Freifräsungen zu der einzelnen Durchkontaktierungsöffnung 10 verbindbar sind, in welche die Sensorleiterplatte 7 einsetzbar ist. Dies ist ebenfalls automatisiert und dadurch einfach, schnell und kostengünstig durchführbar.

Durch diese automatisierte Fertigung sind Montageprobleme minimiert. Durch mehrere durch Freifräsen verbundene Durchkontaktierungen sind in der Durchkontaktierungsöffnung 10 großflächige Hauptleiterplattenkontakte 9 gebildet, wodurch eine sehr gute Verlötung und eine sehr gute Kontaktierung mit den Sensorleiterplattenkontakten 8 ermöglicht ist.

Um eine einfache Fertigung des Heizkostenverteilers 1 zu ermöglichen, ist die Sensorleiterplatte 7 in den aus Gründen der Übersichtlichkeit in den Figuren 5 und 6 nicht dargestellten Träger 12 einzusetzen und erst danach ist das erste Ende 7.1 der Sensorleiterplatte 7 in die Durchkontaktierungsöffnung 10 der Hauptleiterplatte 6 einzusetzen und sind die Hauptleiterplattenkontakte 9 mit den Sensorleiterplattenkontakten 8 zu verlöten.

### BEZUGSZEICHENLISTE

- 1: Heizkostenverteiler
- 2: Heizkörpertemperatursensor
- 3: Raumlufttemperatursensor
- 4: Gehäuse
- 4.1: Gehäusevorderteil
- 4.2: Gehäuserückseite
- 4.3: Gehäusemittelwand
- 5: Batterie
- 6: Hauptleiterplatte
- 7: Sensorleiterplatte
- 7.1: erstes Ende der Sensorleiterplatte
- 7.2: zweites Ende der Sensorleiterplatte
- 7.3: Schmalseite der Sensorleiterplatte
- 7.4: Breitseite der Sensorleiterplatte
- 8: Sensorleiterplattenkontakt
- 9: Hauptleiterplattenkontakt
- 10: Durchkontaktierungsöffnung
- 11: dünnwandiger Bereich
- 12: Träger
- 13: Anzeigeeinheit
- 14: Bauraum
- 15: thermisch isolierendes Element
- 16: Wärmeleitelement
- 17: Federelement
- 18: Verdrahtung
- 19: Leiterplattennutzen
- 20: Leiterzug

## Patentansprüche

1. Heizkostenverteiler (1) zur Messung einer von einem Heizkörper abgegebenen Wärmemenge, mit einem Gehäuse (4), welches ein Gehäusevorderteil (4.1) und eine Gehäuserückseite (4.2) aufweist, mit einem Heizkörpertemperatursensor (2), einem Raumlufttemperatursensor (3) und einer Hauptleiterplatte (6), wobei
die Hauptleiterplatte (6) in Längsrichtung des Heizkostenverteilers (1) im Gehäuse (4) angeordnet ist,
**dadurch gekennzeichnet, dass**
senkrecht zu dieser Hauptleiterplatte (6) eine Sensorleiterplatte (7) angeordnet ist, wobei ein erstes Ende (7.1) der Sensorleiterplatte (7) in einer Durchkontaktierungsöffnung (10) der Hauptleiterplatte (6) angeordnet ist und ein zweites Ende (7.2) der Sensorleiterplatte (7) im Bereich des Gehäusevorderteils (4.1) angeordnet ist, wobei die Sensorleiterplatte (7) mit der Hauptleiterplatte (6) im Bereich der Durchkontaktierungsöffnung (10) über Hauptleiterplattenkontakte (9) und Sensorleiterplattenkontakte (8) elektrisch kontaktiert ist und wobei auf dem zweiten Ende (7.2) der Sensorleiterplatte (7) der Raumlufttemperatursensor (3) angeordnet ist.

2. Heizkostenverteiler (1) nach Anspruch 1, **dadurch gekennzeichnet, dass** das zweite Ende (7.2) der Sensorleiterplatte (7) an einem dünnwandigen Bereich (11) des Gehäusevorderteils (4.1) angeordnet ist.

3. Heizkostenverteiler (1) nach Anspruch 2, **dadurch gekennzeichnet, dass** zwischen dem Raumlufttemperatursensor (3) und dem dünnwandigen Bereich (11) des Gehäusevorderteils (4.1) ein Wärmeleitmittel angeordnet ist.

4. Heizkostenverteiler (1) nach einem der Ansprüche 1 bis 3,
**dadurch gekennzeichnet, dass** die Sensorleiterplattenkontakte (8) im Bereich des ersten Endes (7.1) der Sensorleiterplatte (7) jeweils eine Schmalseite (7.3) der Sensorleiterplatte (7) vollständig und einen angrenzenden Bereich einer unteren und einer oberen Breitseite (7.4) der Sensorleiterplatte (7) nahezu bis zur jeweiligen Seitenmitte bedecken.

5. Heizkostenverteiler (1) nach einem der vorhergehenden Ansprüche,
**dadurch gekennzeichnet, dass** Leiterzüge (20) für eine elektrische Kontaktierung der Sensorleiterplattenkontakte (8) mit dem Raumlufttemperatursensor (3) auf der Sensorleiterplatte (7) mäanderförmig angeordnet sind.

6. Heizkostenverteiler (1) nach einem der vorhergehenden Ansprüche,
**dadurch gekennzeichnet, dass** die Hauptleiterplatte (6) in einem mittleren Bereich zwischen dem Gehäusevorderteil (4.1) und der Gehäuserückseite (4.2) des Gehäuses (4) angeordnet ist.

7. Heizkostenverteiler (1) nach einem der vorhergehenden Ansprüche,
**dadurch gekennzeichnet, dass** der Heizkörpertemperatursensor (2) mit der Gehäuserückseite (4.2) des Gehäuses (4) thermisch kontaktiert ist.

8. Heizkostenverteiler (1) nach einem der vorhergehenden Ansprüche,
**dadurch gekennzeichnet, dass** der Heizkörpertemperatursensor (2) im Gehäuse (4) an der Gehäuserückseite (4.2) und/oder an zumindest einem Wärmeleitelement (16) der Gehäuserückseite (4.2) angeordnet ist.

9. Heizkostenverteiler (1) nach einem der vorhergehenden Ansprüche,
**dadurch gekennzeichnet, dass** der Heizkörpertemperatursensor (2) von der Hauptleiterplatte (6) beabstandet ist und über eine Verdrahtung (18) mit dieser elektrisch kontaktiert ist.

## Claims

1. Heat cost allocator (1) for measuring a quantity of heat which is output by a radiator, having a housing (4) which has a housing front part (4.1) and a housing rear side (4.2), having a radiator temperature sensor (2), an ambient air temperature sensor (3) and a main printed circuit board (6), wherein
the main printed circuit board (6) is arranged in the housing (4) in the longitudinal direction of the heat cost allocator (1),
**characterized in that**
a sensor printed circuit board (7) is arranged perpendicular to this main printed circuit board (6), wherein a first end (7.1) of the sensor printed circuit board (7) is arranged in a via opening (10) in the main printed circuit board (6), and a second end (7.2) of the sensor printed circuit board (7) is arranged in the region of the housing front part (4.1), wherein the main printed circuit board (6) makes electrical contact with the sensor printed circuit board (7) in the region of the via opening (10) by means of main printed circuit board contacts (9) and sensor printed circuit board contacts (8), and wherein the atmospheric air temperature sensor (3) is arranged on the second end (7.2) of the sensor printed circuit board (7).

2. Heat cost allocator (1) according to Claim 1, **characterized in that** the second end (7.2) of the sensor printed circuit board (7) is arranged on a thin-walled region (11) of the housing front part (4.1).

3. Heat cost allocator (1) according to Claim 2, **characterized in that** a heat-conducting means is arranged between the ambient air temperature sensor (3) and the thin-walled region (11) of the housing front part (4.1).

4. Heat cost allocator (1) according to one of Claims 1 to 3, **characterized in that** the sensor printed circuit board contacts (8) in the region of the first end (7.1) of the sensor printed circuit board (7) cover in each case a narrow side (7.3) of the sensor printed circuit board (7) completely and an adjoining region of a lower and an upper broad side (7.4) of the sensor printed circuit board (7) almost as far as the middle of the respective sides.

5. Heat cost allocator (1) according to one of the preceding claims, **characterized in that** conductor tracks (20) for establishing an electrical contact between the sensor printed circuit board contacts (8) and the ambient air temperature sensor (3) are arranged on the sensor printed circuit board (7) in a meandering manner.

6. Heat cost allocator (1) according to one of the preceding claims, **characterized in that** the main printed circuit board (6) is arranged in a central region between the housing front part (4.1) and the housing rear side (4.2) of the housing (4).

7. Heat cost allocator (1) according to one of the preceding claims, **characterized in that** the radiator temperature sensor (2) makes thermal contact with the housing rear side (4.2) of the housing (4).

8. Heat cost allocator (1) according to one of the preceding claims, **characterized in that** the radiator temperature sensor (2) is arranged in the housing (4) on the housing rear side (4.2) and/or on at least one heat-conducting element (16) of the housing rear side (4.2).

9. Heat cost allocator (1) according to one of the preceding claims, **characterized in that** the radiator temperature sensor (2) is at a distance from the main printed circuit board (6) and electrically contacted with said main printed circuit board by means of a wiring arrangement (18).

## Revendications

1. Répartiteur (1) de dépenses de chauffage, destiné à mesurer une quantité de chaleur délivrée par un corps de chauffe et présentant un boîtier (4) qui présente une partie avant (4.1) de boîtier et une partie arrière (4.2) de boîtier, un capteur (2) de température du corps de chauffe, un capteur (3) de la température de l'air ambiant et une carte (6) de circuit principal,
la carte (6) de circuit principal étant disposée dans le boîtier (4) dans le sens de la longueur du répartiteur (1) de dépenses de chauffage, **caractérisé en ce que**
une carte (7) de circuit de capteur est disposée perpendiculairement à cette carte (6) de circuit principal,
**en ce qu'**une première extrémité (7.1) de la carte (7) de circuit de capteur est disposée dans une ouverture (10) de passage de contact de la carte (6) de circuit principal et une deuxième extrémité (7.2) de la carte (7) de circuit de capteur est disposée au niveau de la partie avant (4.1) du boîtier,
**en ce que** la carte (7) de circuit de capteur est mise en contact électrique avec la carte (6) de circuit principal au niveau de l'ouverture (10) de passage de contact par l'intermédiaire de contacts (9) de carte de circuit principal et de contacts (8) de carte de circuit de capteur et
**en ce que** le capteur (3) de température de l'air ambiant est disposé sur la deuxième extrémité (7.2) de la carte (7) de circuit de capteur.

2. Répartiteur (1) de dépenses de chauffage selon la revendication 1, **caractérisé en ce que** la deuxième extrémité (7.2) de la carte (7) de circuit de capteur est disposée sur une partie (11) en paroi mince de la partie avant (4.1) du boîtier.

3. Répartiteur (1) de dépenses de chauffage selon la revendication 2, **caractérisé en ce qu'**un agent conducteur de chaleur est disposé entre le capteur (3) de température de l'air ambiant et la partie (11) en paroi mince de la partie avant (4.1) du boîtier.

4. Répartiteur (1) de dépenses de chauffage selon l'une des revendications 1 à 3, **caractérisé en ce qu'**au niveau de la première extrémité (7.1) de la carte (7) de circuit de capteur, les contacts (8) de carte de circuit de capteur recouvrent complètement un côté étroit (7.3) de la carte (7) de circuit de capteur et une partie adjacente d'un large côté inférieur et d'un large côté supérieur (7.4) de la carte (7) de circuit de capteur presque jusqu'au milieu du côté concerné.

5. Répartiteur (1) de dépenses de chauffage selon l'une des revendications précédentes, **caractérisé en ce que** des pistes conductrices (20) permettant la mise en contact électrique des contacts (8) de carte de circuit de capteur et le capteur (3) de température de l'air ambiant sont disposés en méandres sur la carte (7) de circuit de capteur.

6. Répartiteur (1) de dépenses de chauffage selon l'une des revendications précédentes, **caractérisé en ce que** la carte (6) de circuit principal est disposée dans une partie centrale située entre la partie avant (4.1) du boîtier et la partie arrière (4.2) du boîtier (4).

7. Répartiteur (1) de dépenses de chauffage selon l'une des revendications précédentes, **caractérisé en ce que** le capteur (2) de température du corps de chauffe est en contact thermique avec le côté arrière (4.2) du boîtier (4).

8. Répartiteur (1) de dépenses de chauffage selon l'une des revendications précédentes, **caractérisé en ce que** le capteur (2) de température du corps de chauffe est disposé sur le côté arrière (4.2) du boîtier (4) et/ou au moins sur un élément (16) conducteur de chaleur du côté arrière (4.2) du boîtier.

9. Répartiteur (1) de dépenses de chauffage selon l'une des revendications précédentes, **caractérisé en ce que** le capteur (2) de température du corps de chauffe est maintenu à distance de la carte (6) de circuit principal et est mis en contact électrique avec cette dernière par l'intermédiaire d'un câblage (18).
